# EUROPÄISCHE PATENTSCHRIFT

(11) **EP 0 619 920 B1**
(45) Veröffentlichungstag und Bekanntmachung des Hinweises auf die Patenterteilung: **06.10.1999**
(21) Anmeldenummer: 93901655.6
(22) Anmeldetag: 30.12.1992
(51) Int. Cl.: H01L 27/02, H01L 21/76, H01L 29/06

(54) **INTEGRIERTE SCHALTUNG**
INTEGRATED CIRCUIT
CIRCUIT INTEGRE

(30) Priorität: 30.12.1991 DE 4143209
(43) Veröffentlichungstag der Anmeldung: 19.10.1994
(73) Patentinhaber: HÖFFLINGER, Bernd, D-70569 Stuttgart (DE)
(72) Erfinder: HÖFFLINGER, Bernd, Allmandring 30a D-70569 Stuttgart (DE); DUDEK, Volker, D-7015 Korntal-Münchingen 2 (DE)
(74) Vertreter: Münich, Wilhelm, Dr.
(86) Internationale Anmeldenummer: DE9201090
(87) Internationale Veröffentlichungsnummer: WO9313547

(56) Entgegenhaltungen:
- EP-A- 0 108 945
- CH-A- 493 097
- US-A- 4 631 570
- US-A- 4 819 052
- US-A- 5 065 216
- T. OHNO et. al., Electronics Letters, vol. 25 (1989) no. 16, Stevenage, 1071-1072

## Beschreibung

### Technisches Gebiet

Die Erfindung bezieht sich auf eine integrierte Schaltung mit wenigstens zwei aktiven Bauelementen, wie Transistoren.

### Stand der Technik

Derartige integrierte Schaltungen sind allgemein bekannt und werden derzeit in den verschiedensten "MOS" und/oder Bipolartechnologien in großen Stückzahlen gefertigt.

Generell wird dzt. versucht, die Strukturen der Schaltungen weiter zu verkleinern, um einerseits die Pakkungsdichte und andererseits die Taktfrequenz zu erhöhen.

Insbesondere bei der Skalierung der gegenwärtig üblichen CMOS-Technologien in den Submikrometer-Strukturbereich treten eine Reihe von Problemen auf. Hierbei ist zu berücksichtigen, daß typische Strukturmaße gegenwärtig in der Fertigung befindlicher Schaltungen in der Größenordnung von 0,8 um liegen, während typische Strukturmaße gegenwärtig in der Entwicklung befindlicher Schaltungen 0,4 um betragen sollen.

Für diese bei der Skalierung auftretenden Probleme seien als Beispiele genannt:
1. CMOS-Transistoren, die schneller schalten bzw. eine höhere Bandbreite haben, müssen durch Verkleinerung der lateralen und vertikalen Strukturmaße hergestellt werden. Dabei sind viele Komprisse erforderlich, die z.B. dazu führen, daß bei einer Halbierung der Kanallänge nicht mehr die ideale Vervierfachung der Schaltgeschwindigkeit, sondern nur noch eine Erhöhung der Schaltgeschwindigkeit von unter Umständen weniger als 50% erreicht wird. Gleichzeitig nimmt die innere Verstärkung der Transistoren nahezu linear mit der Verkürzung der Strukturmaße ab, so daß diese Transistoren und Schaltungen für schnelle Analog-Schaltungen nicht mehr geeignet sind.
2. Die vergrößerte Packungsdichte verschlimmert die parasitären Effekte wie Übersprechen, Latch-up und Spannungsschwankungen auf den Versorgungsleitungen bei gleichzeitig kleiner werdendem Störabstand der Schaltungen.
3. Die Streuung der elektrischen Transistorenparameter ist generell von der Schwankungsbreite der Strukturierungsparameter abhängig, was bei kleineren Störabständen und stärkerem Übersprechen digitale Schaltungen gefährdet und schnelle analoge CMOS-Schaltungen generell unmöglich macht.
4. Die Verkleinerung der lateralen Strukturmaße bei nicht ähnlich verkleinerbaren Schichtdicken führt dazu, daß die Kontakt- und Übergangswiderstände zunehmen, und daß bei gleichzeitig steigenden Stromdichten Alterungs- und Ausfallprobleme der Schaltungen infolge Materialtransport und metallurgischer Veränderungen von Materialübergängen (z.B. zwischen Silizium und Metallisierungen), Elektromigation auftreten.

In der US-A-5 065 216 wird eine integrierte Halbleiterschaltung beschrieben, die aus einem Substrat besteht, daß eine leitfähige Schicht auf der rückseitigen Oberfläche des Substrates und mehrere Halbleiterschichten auf der vorderseitigen Oberfläche des Substrates hat. Ganz spezielle leitfähige Pfade sind vorgesehen, mit denen Versorgungsspannungen von der Rückseite der Schaltung zu den aktiven Elementen geführt werden können.

In der US-A-4 631 570 wird eine integrierte Schaltung offenbart, die versteckte Oxydisolationen und ein Substrat mit geringem Widerstand offenbart, das geeignet ist, Spannungsversorgungen zu verbinden.

Eine Isolationsstruktur, die aus doppelten und verborgenen Oxydlagen besteht, wird in dem Artikel "Electronic Letters, vol. 25, no. 16, 3. August 1989, Seiten 1071-1072" vorgestellt. Hierbei wird das Konzept des SIMOX verwendet. SIMOX n⁺ Substrate sind allerdings wegen der schlechten Qualität ihrer Oxidunterseite weniger gut geeignet.

### Darstellung der Erfindung

Der Erfindung liegt die Aufgabe zugrunde, eine integrierte Schaltung mit wenigstens zwei aktiven Bauelementen anzugeben, bei der große Packungsdichten bei minimierten Kontakt- und Übersprechproblemen möglich sind.

Eine erfindungsgemäße Lösung dieser Aufgabe ist im Patentanspruch 1 angegeben. Weiterbildungen der Erfindung sind in den Unteransprüchen gekennzeichnet.

Kontakt- und Übersprechprobleme werden durch das "aktive" hochleitende Substrat, das mit dem einen Pol einer Versorgungsspannungsquelle verbunden ist, unterdrückt. Darüberhinaus wird durch das aktive Substrat eine halbe Verdrahtebene gewonnen.

Durch diese erfindungsgemäße Ausbildung lassen sich höchste Packungsdichte bei minimaler Prozeßkomplexität erreichen. Aufgrund der Einfachheit und der Planarität des Aufbaus der erfindungsgemäßen Schaltung werden die Ausbeute optimiert und Herstellkosten minimiert.

Weiterhin sind - u.a. durch die lateralen Isolationen - höchste Ströme pro Flächeneinheit und damit größte Schaltgeschwindigkeiten möglich. Letztlich erlaubt die erfindungsgemäße Ausbildung eine Optimierung von Verstärkung und Bandbreite.

Weiterbildungen der Erfindung sind in den Unteransprüchen gekennzeichnet:

Die lateralen Isolationsgebiete können ebenfalls durch gesperrte p/n-Übergänge oder durch dielektrische Isolationsschichten gebildet werden (Anspruch 5).

Dabei ist es besonders bevorzugt, wenn die lateralen Isolationsgebiete aus in etwa hohlzylindrischen Oxidgebieten bestehen, die mit Material des Leitfähigkeitstyps des hochleitenden Substrats ausgefüllt sind, auf das eine isolierende Deckschicht und insbesondere eine Siliziumoxidschicht aufgebracht ist.

Die Erfindung wird nachstehend ohne Beschränkung des allgemeinen Erfindungsgedankens anhand von Ausführungsbeispielen unter Bezugnahme auf die Zeichnung exemplarisch beschrieben, auf die im übrigen bezüglich der Offenbarung aller im Text nicht näher erläuterten erfindungsgemäßen Einzelheiten ausdrücklich verwiesen wird. Es zeigen:

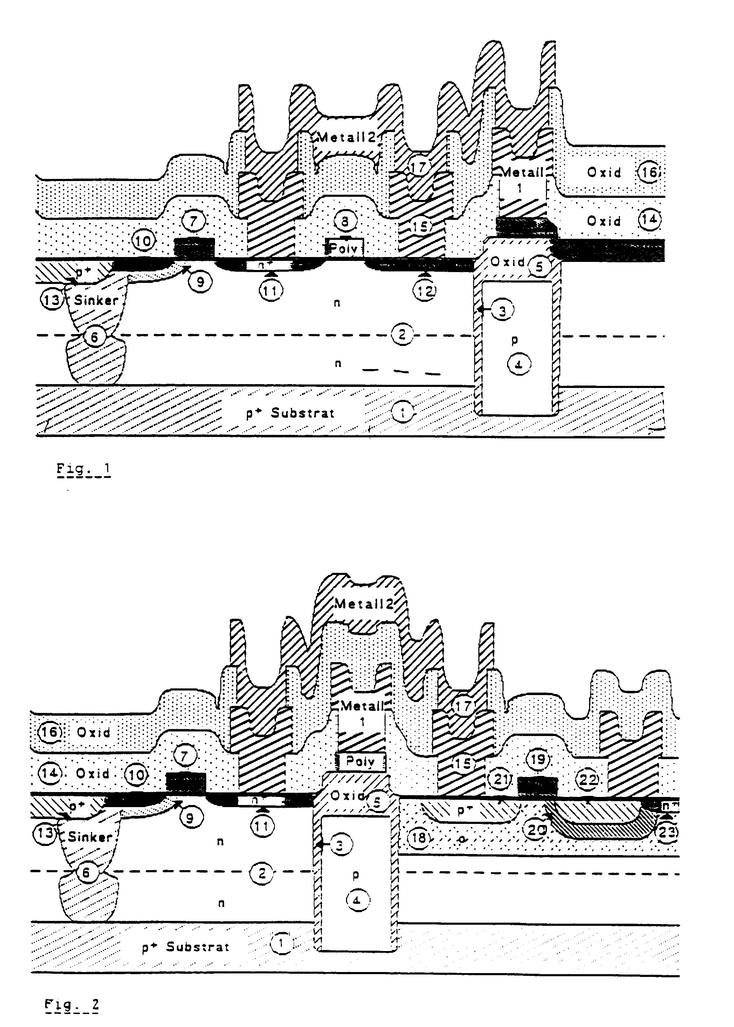

- Fig. 1 bis 11: verschiedene Ausführungsbeispiele der Erfindung.

Fig. 1 zeigt ein erstes Ausführungsbeispiel einer erfindungsgemäßen integrierte Schaltung mit wenigstens zwei aktiven Bauelementen, wie Transisitoren. Die Schaltung weist ein hochleitendes Substrat (1) auf, das mit einem Pol einer Versorgungsspannungsquelle verbunden ist. Durch dieses hochleitende Substrat (1) werden parasitäre Effekte, nämlich Übersprechen bei höherer Packungsdichte, Schwankungen auf den Versorgungsleitungen und Alterungsprobleme an Kontakten deutlich reduziert. Bei dem gezeigten Ausführungsbeispiel wird ein hochdotiertes "aktives" (vorzugsweise p⁺) Substrat (1) verwendet, das zur Stromabführung und als festes Bezugspotential (Masse) dient. Dieses "aktive" Substrat bietet eine "halbe" zusätzliche Verdrahtungsebene. Selbstverständlich kann aber auch ein Substrat eines anderen Leitfähigkeitstyps verwendet werden.

Auf einer Hauptoberfläche des Substrats (1) ist eine halbleitende Schicht (2) aufgebracht, die vorzugsweise ein aktiver, entgegengesetzt dotierter (vorzugsweise N-Typ) Siliziumfilm (2) ist, der durch Epitaxie standardmäßig hergestellt wird. Solche Siliziumscheiben können kostengünstig von Scheibenherstellern bezogen werden. Die Dotierung dieses Films wird so gewählt, daß N-Kanal-Transistoren mit optimalen Driftstrecken, N-Kanal-Transistoren vom Depletionstyp und geeignete Inseln für für P-Kanal-Transistoren entstehen.

Der Film (2) ist gegenüber dem Substrat (1) elektrisch isoliert.

Erfindungsgemäß ist ferner der Film (2) durch laterale Isolationsgebiete in einzelne Bereiche aufgeteilt. Die laterale Isolation erfolgt vorzugsweise durch eine dielektrische Isolation, bei der in eine Oxidwandung (3) ein Siliziumkern (4) eingebracht ist. Hierzu wird als Maske 1 vorzugsweise eine Nitridmaskierung verwendet. Es wird eine Grabenätzung typischerweise mit reaktivem Ionenätzen bis zur Tiefe des p⁺-Substrats (1) durchgeführt, wobei die Tiefe nicht kritisch ist. Die Wände der Gräben werden thermisch oxidiert und danach z.B. durch gerichtetes reaktives Ionenätzen der Oxidboden entfernt. Damit entstehen Siliziumsaatbereiche, aus denen im Epitaxiereaktor selektiv Siliziumkerne aufgewachsen werden können, etwa bis zur Höhe der Siliziumoberfläche. Diese Oberflächen werden sodann thermisch aufoxidiert, so daß ein Feldoxid (5) entsteht, welches nahezu koplanar mit den umgebenden Siliziumoberflächen ist.

An allen Stellen, an denen Kontakte zur negativen Versorgungsspannung (Masse) erforderlich sind, werden p⁺-Tiefdiffusionen (Sinker 6) unter Verwendung einer Maske 2 eingebracht. Diese lateralen Tiefdiffusionsbereiche (6), die in die halbleitende Schicht eingebracht sind, stellen eine leitende Verbindung zwischen dem hochleitenden Substrat (1) und den entsprechenden Gebieten der Schicht (2) her.

Anschließend wird auf allen Siliziuminseln Gateoxid thermisch aufgewachsen und darauf typischerweise Polysilizium als Gate-Material abgeschieden. Die Polysilizium-Bereiche (7,8) werden mit einer Maske 3 strukturiert.

Um in jeden der Bereiche ist wenigstens ein aktives Bauelement in Form eines Transistors mit einem n- oder p- Kanal eingebracht.

Mit einer Fotoresistmaske 4 werden Bereiche (9) freigelegt, in die eine p-Typ Ionenimplantation, z.B. mit Bor derart erfolgt, daß bei den zu bildenden Transistoren die Polysiliziumkanten der Gates als Masken dienen. Diese Borbereiche werden zu einer geeigneten Tiefe eindiffundiert. Nunmehr wird die Siliziumscheibe ganzflächig n⁺ implantiert (z.B. mit Arsen). So entstehen Source- und Drain-Gebiete (10-12) der NMOS Transistoren. Mit einer p⁺-Implantation (Maske 5) werden n⁺ Source, p-Kanal und Sinker verbunden. Es liegen nun NMOS-Transistoren vom sogenannten doppelt-diffundierten Typ vor. Die elektrische Kanallänge dieser Transistoren ist nur vom Unterschied der Diffusionstiefen von Bor und Arsen bestimmt, ähnlich wie die Basisweite in NPN Bipolartransistoren. Die Schwankungen dieser kritischen Abmessungen haben nunmehr mit Schwankungen der lithografischen Strukturierung nichts mehr zu tun, und man erhält Transistoren, die sowohl in mikroskopischen als auch in makroskopischen Bereichen der Siliziumscheiben sehr geringe Schwankungen der elektrischen Parameter aufweisen.

Es liegen nun zwei Typen von NMOS-Transistoren vor. Die doppelt-diffundierten DMOS-Transistoren sind von Enhancement-Typ (normal abgeschaltet). Ihre Funktion kann man verstehen als die Serienschaltung eines Enhancement-Transistors mit extrem kurzer Kanallänge (kleiner als 0,3 µm in Serie mit einer N-leitenden Driftstrecke, die zudem noch von dem darüberliegenden Gate in starke Elektronen-Akkumulation aufgesteuert wird. Dieser Transistortyp zeichnet sich dadurch aus, daß mit dem sehr kurzen Enhancement-Kanal eine sehr große Steilheit, bzw. ein sehr großer Strom produziert wird, und daß die folgende Driftstrecke Potentialeinflüsse vom Drain auf die Source-seitige Steuerstrecke minimiert, so daß eine sehr geringe Kanallängenmodulation und damit eine optimal hohe innere Spannungsverstärkung dieses Transistors erzielt wird. Die mit einer gegebenen Drainspannung (z.B. Versorgungsspannung 5V) über die Driftstrecke verteilte Feldstärke ist so ermäßigt, daß Probleme mit heißen Ladungsträgern und entsprechende Transistor-Degradationen verhindert werden.

Dieser MIS-Transistortyp hat die prinzipiell höchstmögliche Verstärkungs-Bandbreite bzw. Schaltgeschwindigkeit. Außerdem ist in der bisherigen Prozeßfolge ein NMOS-Transistor mit dem Gate (8) entstanden, der vom Depletion-Typ ist, d.h. normal leitend ist. Dieser Transistor ist als gate-gesteuerter Widerstand und damit als Lastelement geeignet. Seine elektrische Kanallänge entspricht der geometrischen Breite des Polysilizium-Gates, die für entsprechende Schaltungen geeignet auszulegen ist.

Eine besonders vorteilhafte Auslegung für die DMOS-Transistoren besteht darin, daß Gate, Drain und ggf. laterale Isolation konzentrisch, bzw. praktisch sechseckig, um Source- und Sinker-Gebiete angeordnet werden.

Es wird nachfolgend das Zwischenoxid aufgebracht auf einer Scheibenoberfläche, die nur infolge der Polysiliziumstrukturen ein Höhenprofil aufweist. Die Konformität dieses Oxids kann damit günstig hergestellt werden. Erleichert wird so auch die die Strukturierung der Kontaktlächer in diesem Isolatorfilm (Maske 6).

Die geringe Oberflächenstruktur wirkt sich auch günstig für die nachfolgenden Filme Metall 1 (Maske 7), Zwischenoxid mit Vias (Maske 8) und Metall 2 (Maske 9) aus.

Damit ergibt sich ein Gesamtprozeß, der mit nur neun Masken eine MOS Technologie für höchste Geschwindigkeiten bietet, die zudem auch noch für sehr hochfrequente analoge Schaltungen geeignet ist. In der Geschwindigkeit ist diese Technologie vergleichbar einer Bi-CMOS-Technologie mit 17 Masken.

Eine erfindungsgemäße integrierte Schaltung (auch als SUPER-MOS-Technologie bezeichnet) mit komplementären DMOS-Transistoren ist in Fig. 2 dargestellt.

Für einen p-Kanal-DMOS-Transistor benötigt man ein p-Gebiet (18) das mit einer Maske 10 vor der Formation der Poly-Gebiete einzubringen ist.

Nach der Strukturierung der Poly-Gates (7, 19) wird mit Maske 11 die N-Basis (20) eingebracht. Danach werden mit der Maske 5 die P+-Gebiete (13, 21, 22) sowie mit Maske 12 die N+-Gebiete (10, 11, 12, 23) eingebracht.

Somit kann eine Submicron-High-Performance komplementäre DMOS-Technologie mit nur 12 Masken hergestellt werden (11 Masken mit Junction Isolation).

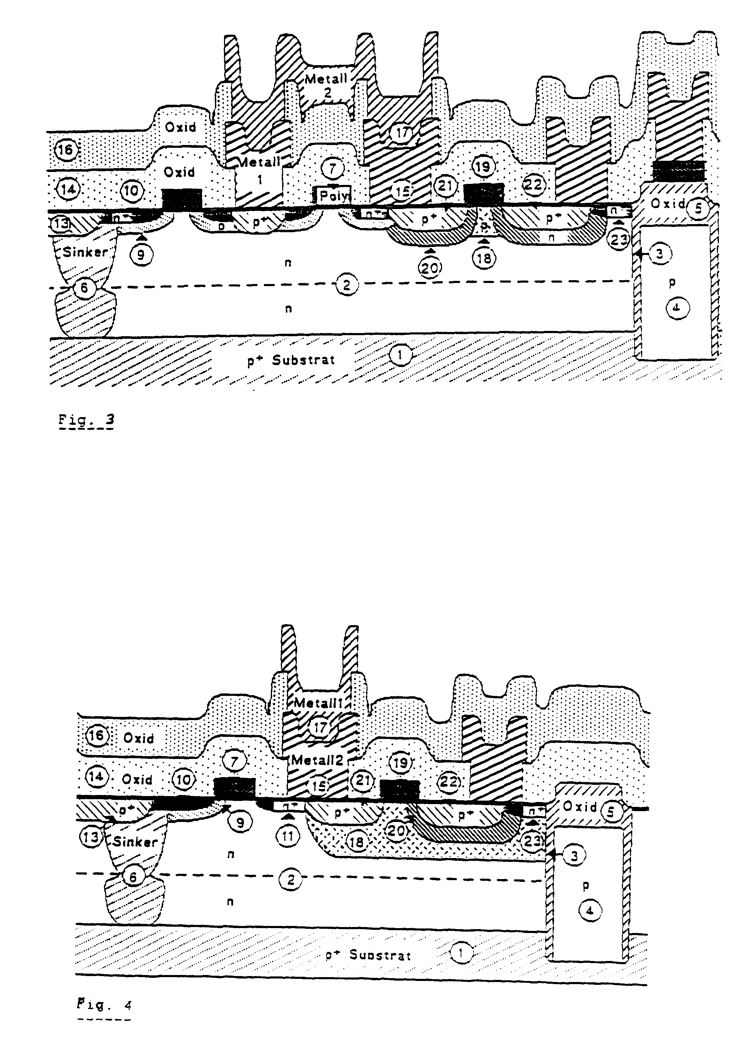

Transistoren mit symmetrischen Basis- bzw. Kanal-Gebieten zur Verwendung in Transmissions-Gates, zur Erhöhung der Transistordichte und zur Einsparung von Masken können gemäß Fig. 3 hergestellt werden.

Für symmetrische, komplementäre, doppelt-diffundierte Transistoren sind gemäß Fig. 3 nur 10 Masken erforderlich:
- Maske 1: Trench (4)
- Maske 2: Sinker (6)
- Maske 3: p-Driftstrecke (18)
- Maske 4: Poly-Gates (7, 19)
- Maske 5: P-Kanal und N+-Gebiete
- Maske 6: N-Kanal und P+-Gebiete
- Maske 7: Kontakte
- Maske 8: Metall 1
- Maske 9: VIA
- Maske 10: Metall 2

Die Eigenschaften dieser symmetrischen Transistoren werden in Steilheit und Gewinn-Bandbreite-Produkt sowie Widerstandsfähigkeit gegen heiße Elektronen etwas schwächer ausfallen als die unsymmetrischen, optimierten Transistoren. Dieser Nachteil wird durch die einfache Prozeßführung aufgehoben.

In den komplementären Schaltungen kann eine hohe Pakkungsdichte dadurch erreicht werden, daß die komplementären Drain-Gebiete bei gemeinsamen Schaltungsknoten ohne laterale Isolation direkt seitlich aneinandergesetzt werden können (Fig. 4).

Für verteilte Einzeltransistoren sowie komplementäre Push-Pull-Stufen mit konzentrischen Gates und Drains kann die laterale Isolation entfallen und damit eine Maske (Trench) eingespart werden.

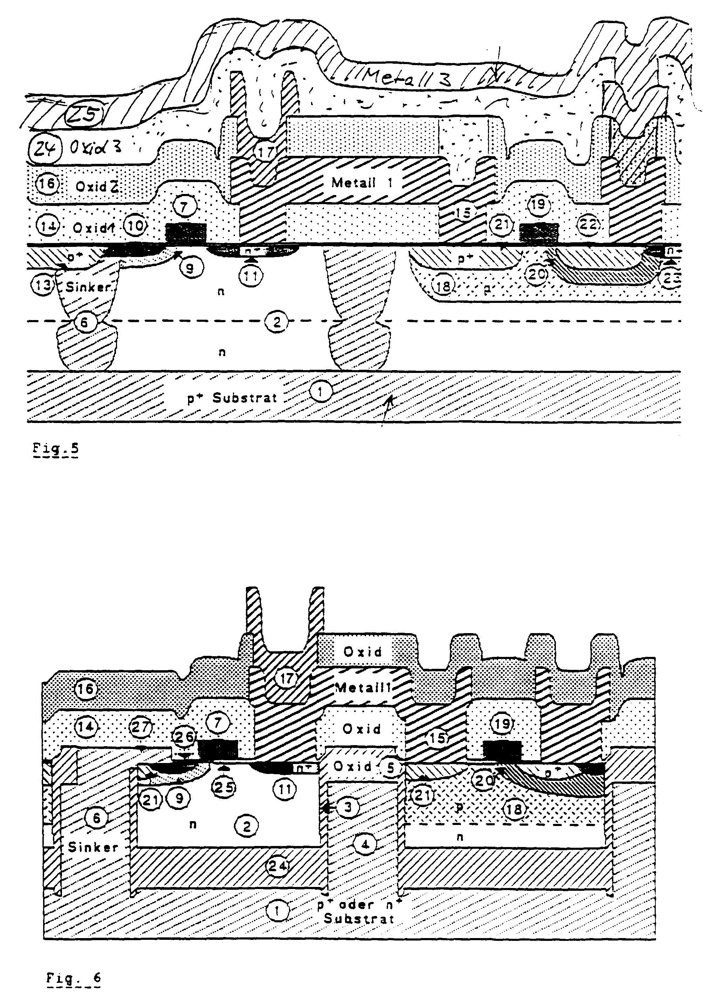

Die laterale Isolation mit Trench ermöglicht die höchste Packungsdichte. Satt dieser kann aber auch ein P+-Gebiet verwendet werden, das gleichzeitig mit dem Sinker (6) erzeugt wird (Fig. 5). Trenchätzung, Wandoxidation und Auffüllung der Gräben mit Silizium entfallen.

Eine Drei-Lagen-Metallisierung hat den Vorteil, daß das dritte Metall (25) ganzflächig für die positive Versorgungsspannung, für die Abführung von Verlustleistung, zur EM-Abschirmung und zur Reduktion von Übersprechen benutzt werden kann.

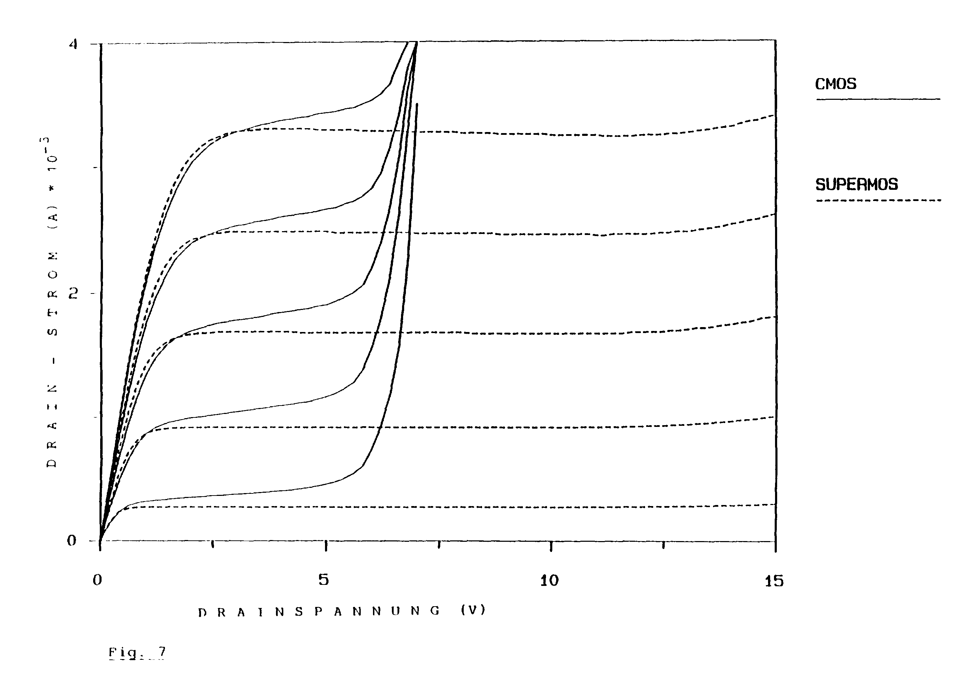

Fig. 6 zeigt ein weiteres Ausführungsbeispiel der Erfindung, bei dem die integrierte Schaltung auf einem Direct Bonding Substrat realisiert wird. In einem ersten Arbeitsgang werden zwei Wafer mit Oxidoberfläche (24) "direct-gebondet". Hierzu werden Handelswafer (1) mit p⁺- oder n⁺-Dotierung verwendet. Das obere Wafer 82) weist bei dem gezeigten Ausführungsbeispiel n-Epidotierung auf. Anschließend wird die obere Siliziumschicht bis auf die n-Epidotierung abgetragen, so daß eine Siliziumschicht mit einer Dicke von 2 bis 5 um verbleibt.

Im zweiten Arbeitsgang werden der Trench und die Sinker erzeugt. Hierzu erfolgt ein Trenchätzen mit einer Maske 1; anschließend werden die Oxidwände (3) dotiert. Wie bei dem im Fig. 1 dargestellten Ausführungsbeispiel wird die Saat mit selektiver Epitaxie (4) geöffnet und die Epitaxie zu einer Schicht (5) autoxidiert. Die selektive Epitaxie erzeugt auch den Sinker (6).

In einem dritten Arbeitsgang erfolgt mit einer Maske 2 die Gateoxidation (25) und das Dünngateoxid (26). Mit einer Maske 3 wird Polysilizium abgeschieden und strukturiert.

In weiteren Arbeitsgängen werden die p-Wanne mit einer Maske 4 sowie die Kanäle (9, 20) und die Source-, Drain- und Bulkgebiet (11, 21) mit Masken 5 bis 8 erzeugt.

Zur Kontaktierung des Sinkers wird die Saat mit einer Maske 9 geätzt. Anschließend erfolgt ein selektiver Epitaxie-Schritt (Gebiet 27). Mit Masken 10 bis 13 wird der Herstellvorgang vervollständigt.

Die hervorrangenden Eigenschaften der erfindungsgemäß hergestellten Baulemente zeigt Fig. 7, in dem der Drain-Strom als Funktion der Drain-Spannung für ein erfindungsgemäßes Bauelement (als SUPERMOS bezeichnet) und einen CMOS-Transistor dargestellt ist.

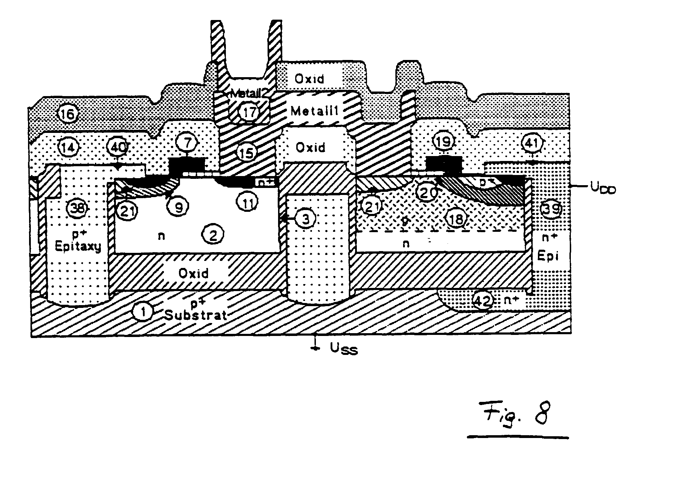

In Fig. 8 ist eine weitere Ausführungsform einer integrierten Schaltung dargestellt, die zudem einen n⁺-diffundierten Streifen 42 in dem p-dotierten Substrat 1 aufweist. Der Streifen 42 ist mit dem positiven Potential der Versorgungsspannung U_{DD} verbunden. Die sich zwischen dem n⁺-dotierten Bereich 42 und dem p⁺-dotierten Substrat ausbildende Raumladezone dient als Sperrschicht für diese beiden Potentiale. Bspw. wird das Source-Gebiet von sogenannten p-SuperMOS-Transistoren über einen entsprechenden Sinker 39 an die n⁺-Streifen 42 angeschlossen. Durch diesen Aufbau gelingt es, die bisher für die Versorgungsspannungszuführung erforderliche (häufig dritte) Verdrahtungsschicht an der Oberfläche der Schaltung einzusparen und in das Silizium zu verlegen. Die Leitungszuführung erfolgt nun ausschließlich über Siliziumstrecken, wodurch heterogene Materialübergänge vermieden werden, die in Folge von Alterungserscheinungen zu einem ganz kritischen Teil von höchst integrierten Schaltungen geworden sind.

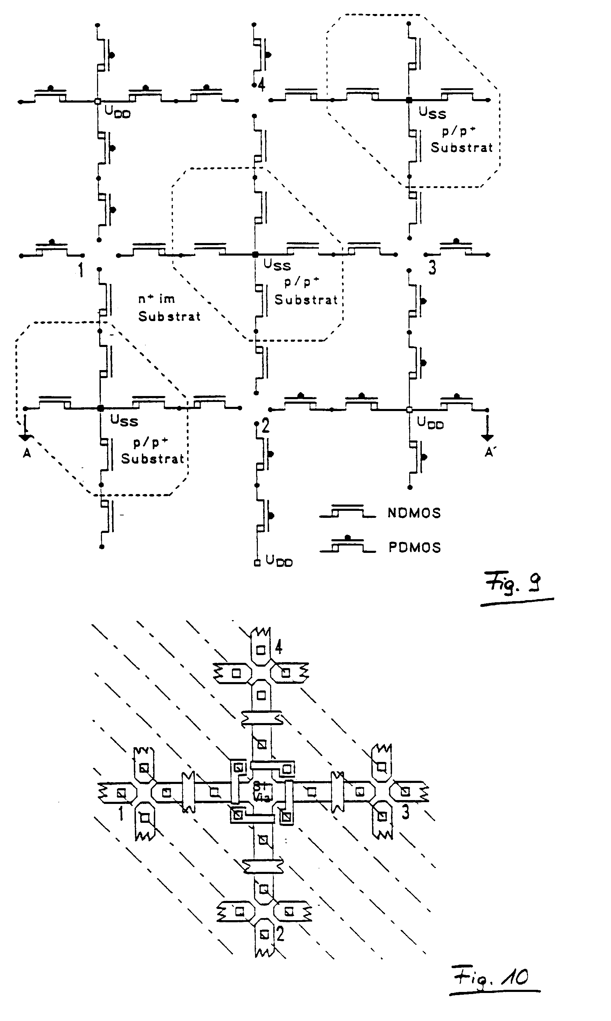

Aus Fig. 9 geht eine vorteihafte Transistoranordnung hervor, die darüberhinaus eine wabenförmige Stromzuführung (gestrichelte Linienführung) mit n⁺-dotierten Leitbahnen zur positiven Spannungsversorgung aufweist. Hierbei ist die positive Versorgungsspannung mit U_{SS} und die negative Versorgungsspannung mit U_{DD} abgekürzt.

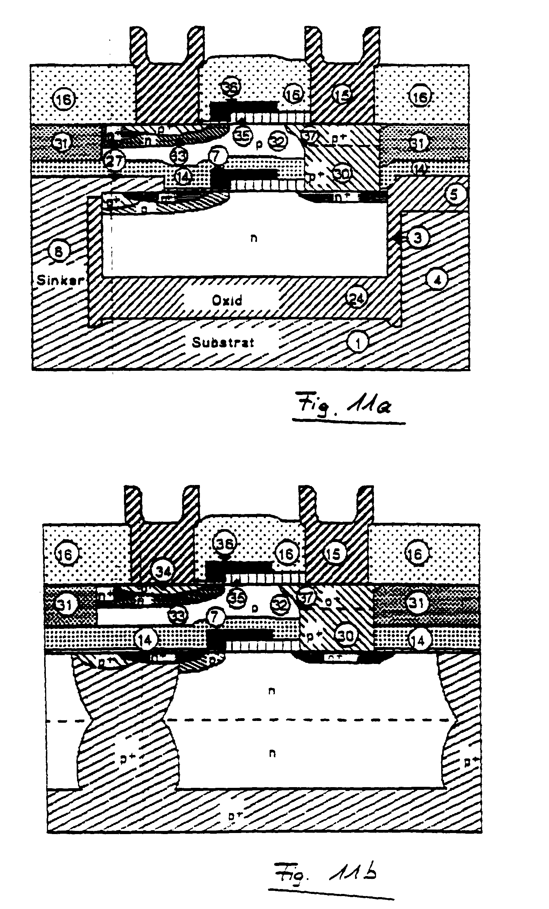

Aus Fig. 10 geht eine bevorzugte Transistoranordnung hervor, die eine sternförmige Transistoranordnung aufweist, mit 45° gedrehter Verdrahtungsrichtung. Da die Verdrahtung gegen den Tranistorstern um 45° gedreht ist, ergibt sich daraus eine sehr kurze Intrazell-Leitungslänge und erlaubt zugleich eine Datenpfad-Struktur.

Aus den Fig. 11a und 11b gehen integrierte Schaltungs-Auslegungsformen hervor, bei denen ein komplementärer Transistor vertikal über dem ersten Transistor angebracht ist. Die entsprechende Herstellfolge beginnt nach dem Zwischenoxid (14). Es wird ein Spacer-Oxid (31) aufgebracht, das die Insel für einen zu fertigenden kristallinen Siliziumdünnfilmtransistor begrenzt. In das Oxid (14) wird nun am Draingebiet des erstgenannten Transistors eine Saatöffnung geätzt. Aus dieser Saatöffnung wird mit selektiven Epitaxie kristallines Silizium aufgewachsen; vorteilhafterweise mit hoher p-Typ-Dotierung. Das selektiv-kristallin-wachsende Silizium setzt sein Wachstum lateral über den Transistor (7) fort und wird schließlich über das Spacer-Oxid (31) weiterwachsen. Die überschüssige Silizium-Aufwachsung wird durch chemo-mechanisches Polieren mit selektiver Wirkung soweit abgetragen, bis der kristalline Filmplan die Insel innerhalb des Spacer-Oxids (31) ausfüllt.

Der epitaktische Film (32) ist bei der Überwachsung vorteilhafterweise p-dotiert. Am fernen Ende der Überwachsung werden nun Source und Gate eines PDMOS-Transistors mit dem Source-Gebiet (34), dem Kanalgebiet (33), dem vorteilhafterweise zwei-stufigen Gate-Oxid (35) sowie dem Gate (36) hergestellt. Die Source-Implantation (34) wird auch zur Herstellung des Drain-Gebiets (37) verwendet. Der so hergestellte Dünnfilm-PDMOS-Transistor kann in jeder Weise von der Prozessführung her optimiert werden; Steilheit, Einschaltwiderstand, Miller-Kapazität, Freiheit von Leckströmen, insbesondere der Unterseite des Films.

Hervorheben ist auch, daß nach diesen Prozeßschritten eine sehr plane Siliziumoberfläche mit nur geringen Topographieunterschieden entstanden ist, die zusätzlich dazu beiträgt, daß eine aggressive Strukturverkleinerung (Miniaturisierung) ohne fundamentale Schwierigkeiten möglich ist. Im Gegenteil ist es besonders kennzeichnend, daß die Herstellung dieses Dünnfilm-Transistor von der fortschreitenden Miniaturisierung profitiert. Denn mit ihr werden die lateralen Dimensionen kleiner und damit das thermische Budget (Produkt von Prozeßtemperatur und Prozeßzeit) für die laterale kristalline Überwachsung reduziert.

Nach dem so erreichten Prozeßstand wird das Zwischenoxid (16) aufgebracht und mit Metall (15) die erste metallische Verdrahtungsebene ausgeführt.

## Patentansprüche

1. Integrierte Schaltung mit wenigstens zwei Transistoren, wobei
- ein hochleitendes halbleitendes Substrat (1) eines ersten Dotierungstyps vorgesehen ist, das mit einem Pol einer Vorsorgungsspannungsquelle verbunden ist,
- über einer Hauptoberfläche des Substrats eine halbleitende Schicht (2) eines, dem ersten Typ entgegengesetzten zweiten Dotierungstyps aufgebracht ist, die gegenüber dem Substrat elektrisch isoliert ist, und die durch laterale Isolationsgebiete (3, 4, 5), die sich bis zum Substrat erstrecken, in einzelne Bereiche aufgeteilt ist,
- in jeden der Bereiche wenigstens ein Transistor mit einem n- oder p-Kanal eingebracht ist,
- Sinker-Bereiche (6) des ersten Dotierungstyps vorgesehen sind, die in die halbleitende Schicht (2) derart eingebracht sind, daß sie sich vom hochleitenden Substrat (1) bis zum jeweiligen halbleitenden Gebiet des Transistors erstrecken und eine direkte, örtlich leitende Verbindung zwischen dem hochleitenden Substrat (1) und den entsprechenden halbleitenden Gebieten der entsprechenden Transistoren zur Versorgungsspannungszuführung der Transistoren herstellen.

2. Integrierte Schaltung nach Anspruch 1,
dadurch **gekennzeichnet**, daß das hochleitende Substrat (1) aus p⁺-Silizium besteht.

3. Integrierte Schaltung nach einem der Ansprüche 1 bis 2,
dadurch **gekennzeichnet**, daß die lateralen Isolationsgebiete durch gesperrte p/n-Übergänge gebildet werden.

4. Integrierte Schaltung nach einem der Ansprüche 1 bis 2,
dadurch **gekennzeichnet**, daß die lateralen Isolationsgebiete durch dielektrische Isolationsschichten gebildet werden.

5. Integrierte Schaltung nach Anspruch 4,
dadurch **gekennzeichnet**, daß die lateralen Isolationsgebiete aus in etwa hohlzylindrischen Oxidgebieten (3) bestehen, die mit Material des Leitfähigkeitstyps des hochleitenden Substrats (4) ausgefüllt sind, auf das eine isolierende Schicht (5) aufgebracht ist.

6. Integrierte Schaltung nach Anspruch 5,
dadurch **gekennzeichnet**, daß die Deckschicht eine Siliziumoxidschicht ist.

7. Integrierte Schaltung nach einem der Ansprüche 1 bis 6,
dadurch **gekennzeichnet**, daß das hochleitende Substrat mit dem negativen Pol einer Versorgungsspannungsquelle verbunden ist.

8. Integrierte Schaltung nach einem der Ansprüche 1 bis 7,
dadurch **gekennzeichnet,** daß in das hochleitende Substrat Bereiche entgegengesetzter Dotierung implementiert sind.

9. Integrierte Schaltung nach Anspruch 8,
dadurch **gekennzeichnet**, daß die Bereiche n⁺-diffundierte Streifen- oder wabenförmige Bereiche sind, die mit dem positiven Pol einer Versorgungsspannungsquellen verbunden sind.

10. Integrierte Schaltung nach einem der Ansprüche 8 oder 9,
dadurch **gekennzeichnet**, daß die aktiven Bauelemente über Tiefdiffusionen, sogenannte Sinker-Bereiche (39), mit dem hochdotierten Substrat bzw. mit den betreffenden Bereichen des Substrates elektrisch verbunden sind.

11. Integrierte Schaltung nach einem der Ansprüche 1 bis 10,
dadurch **gekennzeichnet**, daß eine Vielzahl von aktiven Bauelementem in Form von Transistoren gemäß einer sternförmigen Transistorenanordnung miteinander verschaltet sind.

12. Integrierte Schaltung nach einem der Ansprüche 1 bis 4,
dadurch **gekennzeichnet**, daß komplementär ausgeführte Transistoren, vertikal durch eine Isolationsschicht getrennt, über den Transistoren angeordnet sind.

13. Integrierte Schaltung nach einem der Ansprüche 5 bis 11,
dadurch **gekennzeichnet**, daß in den voneinander isolierten Bereichen komplementäre, d.h. n⁺-p-n-n⁺ NMOS- bzw. p⁺-n-p-p⁺ PMOS-Transistoren eingebracht sind.

## Claims

1. Integrated circuit including at least two transistors, wherein
- a highly conductive semiconductor substrate (1) of a first conductivity type is provided which is connected to one pole of a voltage supply source,
- a semiconductor layer (2) of a second conductivity type opposite to said first type is applied on a main surface of said substrate, which layer (2) is electrically isolated from said substrate and subdivided into individual regions by lateral isolation regions (3, 4, 5) extending up to said substrate,
- at least one transistor with an n- or p-type channel is provided in each of said regions,
- sink regions (6) of the first conductivity type are provided which are so disposed in said semiconductor layer (2) that they extend from said highly conductive substrate (1) up to the respective semiconductor region of the transistor and establish a direct locally conductive connection between said highly conductive substrate (1) and the corresponding semiconductor regions of the corresponding transistors for supplying said transistors with said supply voltage.

2. Integrated circuit according to Claim 1,
**characterised** in that said highly conductive substrate (1) consists of p⁺silicon.

3. Integrated circuit according to any of the Claims 1 to 2,
**characterised** in that said lateral isolation regions are formed by barrier p/n junctions.

4. Integrated circuit according to any of the Claims 1 to 2,
**characterised** in that said lateral isolation regions are formed by dielectric isolation layers.

5. Integrated circuit according to Claim 4,
**characterised** in that said lateral isolation regions consist of approximately hollow cylindrical oxide regions (3) filled with material of the conductivity type of said highly conductive substrate (4), onto which an isolation layer (5) is applied.

6. Integrated circuit according to Claim 5,
**characterised** in that the cover layer is a silicon oxide layer.

7. Integrated circuit according to any of the Claims 1 to 6,
**characterised** in that said highly conductive substrate is connected to the negative pole of a voltage supply source.

8. Integrated circuit according to any of the Claims 1 to 7,
**characterised** in that zones of the opposite conductivity type are implemented in said highly conductive substrate.

9. Integrated circuit according to Claim 8,
**characterised** in that said zones are n⁺-diffused strip or honeycomb-shaped regions which are connected to the positive pole of a supply voltage source.

10. Integrated circuit according to any of the Claims 8 or 9,
**characterised** in that the active components are electrically connected to said highly doped substrate or to the respective regions of the substrate, respectively, via deep diffusion regions, so-called sinker zones (39).

11. Integrated circuit according to Claim 10,
**characterised** in that a plurality of active components in the form of transistors are interconnected in a star-shaped transistor configuration.

12. Integrated circuit according to any of the Claims 1 to 4,
**characterised** in that transistors of a complementary design are arranged above said transistors and vertically isolated therefrom by an isolation layer.

13. Integrated circuit according to any of the Claims 5 to 11,
**characterised** in that complementary transistors, i.e. n⁺-p-n-n⁺ NMOS or p⁺-n-p-p⁺ PMOS transistors, are provided in said regions isolated from each other.

## Revendications

1. Circuit intégré comprenant au moins deux transistors, dans lequel
- un substrat semiconducteur à haute conductibilité (1) d'un premier type de conductibilité est disposé, qui est relié à un pôle d'une source de tension d'alimentation,
- une couche semiconductrice (2) d'un deuxième type de conductibilité opposé audit premier type est appliquée sur une aire principale dudit substrat, qui est électriquement isolé dudit substrat et divisée en régions individuelles par des régions d'isolation latérales (3, 4, 5), qui s'étendent jusqu'au dit substrat,
- au moins un transistor à une voie du type n- ou p- est disposé dans chacune desdites régions,
- des régions d'enfoncement (6) du premier type de conductibilité sont prévues, qui sont disposées dans ladite couche semiconductrice (2) de façon qu'elles s'étendent dudit substrat (1) à haute conductibilité jusqu'à la région semiconductrice respective du transistor et établissent une connexion localement conductrice directe entre ledit substrat à haute conductibilité (1) et les régions semiconductrices correspondantes des transistors correspondants pour l'alimentation lesdits transistors en tension d'alimentation.

2. Circuit intégré selon la revendication 1,
**caractérisé en ce** que ledit substrat à haute conductibilité (1) consiste en silicium p⁺.

3. Circuit intégré selon une quelconque des revendications 1 à 2,
**caractérisé en ce** que lesdites régions d'isolation latérales sont formées par des jonctions p-n de blocage.

4. Circuit intégré selon une quelconque des revendications 1 à 2,
**caractérisé en ce** que lesdites régions d'isolation latérales sont formées par des couches d'isolation diélectriques.

5. Circuit intégré selon la revendication 4,
**caractérisé en ce** que lesdites régions d'isolation latérales sont formées par des régions en oxyde (3) à forme approximative d'un cylindre creux, qui sont remplies d'un matériau du type de conductibilité dudit substrat à haute conductibilité (4), sur lequel une couche isolante (5) est appliquée.

6. Circuit intégré selon la revendication 5,
**caractérisé en ce** que la couche de couverture est une couche en oxyde de silicium.

7. Circuit intégré selon une quelconque des revendications 1 à 6,
**caractérisé en ce** que ledit substrat à haute conductibilité est relié au pôle négatif d'une source de tension d'alimentation.

8. Circuit intégré selon une quelconque des revendications 1 à 7,
**caractérisé en ce** que des zones du type de conductibilité opposée sont réalisées dans ledit substrat à haute conductibilité,

9. Circuit intégré selon la revendication 8,
**caractérisé en ce** que lesdites zones sont des régions en bande à diffusion du type n⁺ ou en forme de à nid d'abeilles, qui sont reliées au pôle positif d'une source de tension d'alimentation.

10. Circuit intégré selon une quelconque des revendications 8 ou 9,
**caractérisé en ce** que les éléments actifs sont électriquement reliés audit substrat fortement dopé ou respectivement aux régions respectives du substrat via des régions à diffusion profonde, des régions dites zones d'enfoncement (39).

11. Circuit intégré selon la revendication 10,
**caractérisé en ce** qu'une pluralité des éléments actifs sous forme de transistors sont reliés l'un à l'autre en une structure de transistors en montage en étoile.

12. Circuit intégré selon une quelconque des revendications 1 à 4,
**caractérisé en ce** que des transistors d'une structure complémentaire sont disposés au dessus desdits transistors et verticalement isolés des dernier par une couche isolante.

13. Circuit intégré selon une quelconque des revendications 5 à 11,
**caractérisé en ce** que des transistors complémentaires, c'est à dire des transistors du type n⁺-p-n-n⁺ NMOS ou du type p⁺-n-p-p⁺ PMOS, sont disposés dans lesdites régions isolées l'une de l'autre.
